# EUROPEAN PATENT APPLICATION

(11) **EP 4 597 757 A1**
(43) Date of publication of application: **06.08.2025**
(21) Application number: 25154390.6
(22) Date of filing: 28.01.2025
(51) Int. Cl.: H01R 12/52, H01R 12/58, H01R 13/20

(54) **MECHANICAL SNAP LOCKING**

(30) Priority: 01.02.2024 IN 202411006723
(71) Applicant: Honeywell International Inc., Charlotte, NC 28202 (US)
(72) Inventor: GANGARAJU,, Charlotte, 28202 (US); ARUMUGAM, ArulSelvam, Charlotte, 28202 (US); BALEKUNDRI, Vishwanath, Charlotte, 28202 (US)
(74) Representative: Haseltine Lake Kempner LLP

(57) **Abstract**

An apparatus is provided. The apparatus includes a male terminal. The apparatus includes a female terminal. The female terminal includes a set of cut slots. The male terminal includes a set of spring features. The set of spring features are configured to lock with the set of cut slots when the male terminal and the female terminal are engaged.

## Description

### FIELD OF THE INVENTION

Various embodiments described herein relate generally to a locking apparatus, and more particularly to a mechanical snap locking apparatus.

### BACKGROUND

It is often desirable to establish electrical connection between components, such as printed circuit board assemblies. Applicant has identified many technical challenges and difficulties associated with precision, reliability, and safety of previous methods of establishing electrical connection, such as soldering. Through applied effort, ingenuity, and innovation, many of these identified problems have been solved by developing solutions that are included in embodiments of the present disclosure, many examples of which are described in detail herein.

### BRIEF SUMMARY

In one or more embodiments, an apparatus is provided including a male terminal. In some embodiments, the apparatus includes a female terminal. In some embodiments, the female terminal includes a set of cut slots. In some embodiments, the male terminal includes a set of spring features. In some embodiments, the set of spring features are configured to lock with the set of cut slots when the male terminal and the female terminal are engaged.

In one or more embodiments, the set of spring features comprises a set of flag snap features.

In one or more embodiments, the set of spring features includes a first spring feature and a second spring feature, where the first spring feature and the second spring feature are 180 degrees apart.

In one or more embodiments, at least one of the male terminal or the female terminal includes an additional set of spring features, where the additional set of spring features is configured to be coupled to a printed circuit board.

In one or more embodiments, the set of spring features and the additional set of spring features each include two spring features, where each spring feature of the set of spring features and the additional set of spring features are 90 degrees apart.

In one or more embodiments, the additional set of spring features includes an upper spring feature and a lower spring feature, where the upper spring feature and the lower spring feature are 180 degrees apart.

In one or more embodiments, the male terminal includes a first additional set of spring features configured to be coupled to a first printed circuit board and the female terminal includes a second additional set of spring features configured to be coupled to a second printed circuit board.

In one or more embodiments, each of the male terminal and the female terminal are cylindrical.

In one or more embodiments, each of the male terminal and the female terminal are made of sheet metal.

In one or more embodiments, the apparatus includes a hydrogen sensor.

In one or more embodiments, the female terminal is partially embedded within a housing.

In one or more embodiments, the female terminal includes a 90-degree bend underneath an engagement area, where the female terminal and the male terminal are engaged at the engagement area.

In one or more embodiments, a locking conductor is provided including a male terminal. In some embodiments, the locking conductor includes a female terminal. In some embodiments, the female terminal includes a set of cut slots. In some embodiments, the male terminal includes a set of spring features. In some embodiments, the set of spring features are configured to lock with the set of cut slots when the male terminal and the female terminal are engaged.

In one or more embodiments, the set of spring features comprises a set of flag snap features.

In one or more embodiments, the set of spring features includes a first spring feature and a second spring feature, where the first spring feature and the second spring feature are 180 degrees apart.

In one or more embodiments, at least one of the male terminal or the female terminal includes an additional set of spring features, where the additional set of spring features is configured to be coupled to a printed circuit board.

In one or more embodiments, the set of spring features and the additional set of spring features each include two spring features, where each spring feature of the set of spring features and the additional set of spring features are 90 degrees apart.

In one or more embodiments, the additional set of spring features includes an upper spring feature and a lower spring feature, where the upper spring feature and the lower spring feature are 180 degrees apart.

In one or more embodiments, the male terminal includes a first additional set of spring features configured to be coupled to a first printed circuit board and the female terminal includes a second additional set of spring features configured to be coupled to a second printed circuit board.

In one or more embodiments, each of the male terminal and the female terminal are cylindrical.

In one or more embodiments, each of the male terminal and the female terminal are made of sheet metal.

In one or more embodiments, the locking conductor is part of a hydrogen sensor.

In one or more embodiments, the female terminal is partially embedded within a housing.

In one or more embodiments, the female terminal includes a 90-degree bend underneath an engagement area, where the female terminal and the male terminal are engaged at the engagement area.

### BRIEF DESCRIPTION OF THE DRAWINGS

Reference will now be made to the accompanying drawings, which are not necessarily drawn to scale, and wherein:
FIGS. 1A-1C depict a female terminal with cut slots in accordance with various embodiments of the present disclosure.
FIGS. 2A-2C depict a male terminal with spring features in accordance with various embodiments of the present disclosure.
FIGS. 3A-3C depict a locking conductor comprising male and female terminals locked together and coupled to printed circuit boards in accordance with various embodiments of the present disclosure.
FIGS. 4A-4B depict a locking conductor comprising spring features of a male terminal being locked with cut slots of a female terminal in accordance with various embodiments of the present disclosure.
FIG. 5 depicts a printed circuit board assembly stack in accordance with various embodiments of the present disclosure.

### DETAILED DESCRIPTION

The present disclosure more fully describes various embodiments with reference to the accompanying drawings. It should be understood that some, but not all embodiments are shown and described herein. Indeed, the embodiments may take many different forms, and accordingly this disclosure should not be construed as limited to the embodiments set forth herein. Rather, these embodiments are provided so that this disclosure will satisfy applicable legal requirements. Like numbers refer to like elements throughout.

It should be understood at the outset that although illustrative implementations of one or more aspects are illustrated below, the disclosed systems, and methods may be implemented using any number of techniques, whether currently known or not yet in existence. The disclosure should in no way be limited to the illustrative implementations, drawings, and techniques illustrated below, but may be modified within the scope of the appended claims along with their full scope of equivalents. While values for dimensions of various elements are disclosed, the drawings may not be to scale.

The words "example," or "exemplary," when used herein, are intended to mean "serving as an example, instance, or illustration." Any implementation described herein as an "example" or "exemplary embodiment" is not necessarily preferred or advantageous over other implementations.

As used herein, the term "or" is intended to mean an inclusive "or" rather than an exclusive "or". That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. In addition, the articles "a" and "an" as used in this application and the appended claims should generally be construed to mean "one or more" unless specified otherwise or clear from context to be directed to a singular form.

As used herein, the terms "coupled," "fixed," "attached to," and the like refer to both direct coupling, fixing, or attaching, as well as indirect coupling, fixing, or attaching through one or more intermediate components or features, unless otherwise specified herein.

As used herein, the term "positioned directly on" refers to a first component being positioned on a second component such that they make contact. Similarly, as used herein, the term "positioned directly between" refers to a first component being positioned between a second component and a third component such that the first component makes contact with both the second component and the third component. In contrast, a first component that is "positioned between" a second component and a third component may or may not have contact with the second component and the third component. Additionally, a first component that is "positioned between" a second component and a third component is positioned such that there may be other intervening components between the second component and the third component other than the first component.

It is desirable, in some examples, to avoid soldering to connect printed circuit board assemblies. Embodiments of the present disclosure include, but are not limited to, a mechanical snap locking apparatus that is reliable, strong, and reduces health and safety issues.

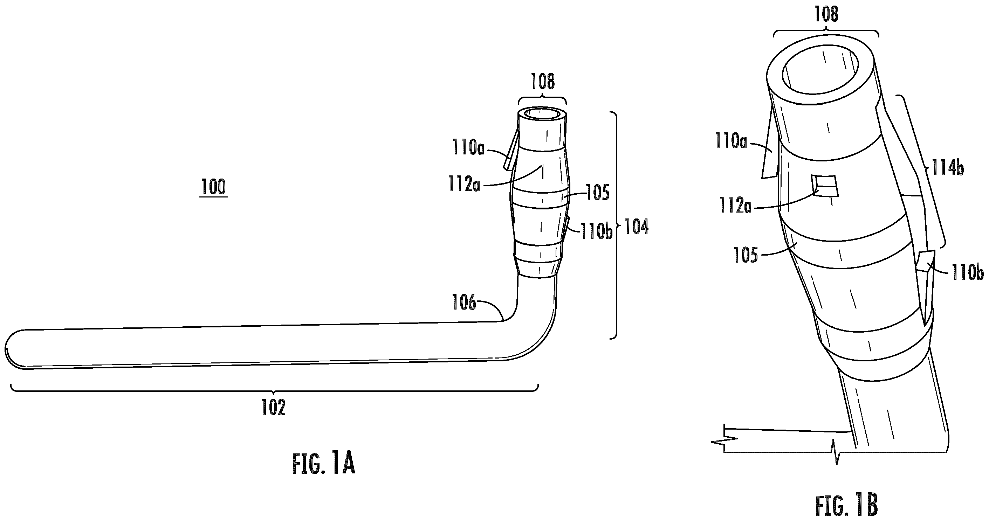

Turning now to FIG. 1A, an example female terminal 100 is depicted. In one or more embodiments, the female terminal 100 is a cylindrical terminal. In some examples, female terminal 100 comprises a horizontal portion 102 and a vertical portion 104. In some examples, the horizontal portion 102 is longer than the vertical portion 104. For example, the horizontal portion 102 may be longer than the vertical portion 104 and embedded in a housing in order to provide stability to the female terminal 100. In other examples, vertical portion 104 may be longer than horizontal portion 102 (e.g., to support connecting a larger number of printed circuit board assemblies.

In one or more embodiments, the horizontal portion 102 and the vertical portion 104 may be connected by a bend 106. In some examples, bend 106 is 90 degrees. In some examples, the bend 106 is rounded or chamfered.

In one or more embodiments, vertical portion 104 varies in diameter. For example, vertical portion 104 may begin to widen in diameter above bend 106. Vertical portion 104 may reach a mid-point 105 where its diameter is widest and then narrow towards the top of vertical portion 104. Vertical portion 104 may be chamfered such that it widens and narrows gradually above bend 106.

In one or more embodiments, female terminal 100 defines an opening 108. In some examples, opening 108 is defined at the top of vertical portion 104. For example, opening 108 may be an entrance to a hollow tube defined by female terminal 100. In some examples, opening 108 has a wider diameter than a male terminal such that the female terminal 100 may engage the male terminal.

Turning now to FIG. 1B, a close-up view of the vertical portion 104 is provided. In some examples, the vertical portion 104 comprises a set of cut slots 112a-112b and a set of additional spring features 110a-110b.

In one or more embodiments, as shown in FIG. 1B, cut slot 112a is defined by vertical portion 104. In some examples, cut slot 112a has dimensions of at least 0.5mm x 0.5mm in order to lock with and release from a spring feature of a male terminal. In some examples, cut slot 112a is defined on an opposite side of vertical portion 104 from cut slot 112b (i.e., they are 180 degrees apart). For example, cut slot 112a may be 90 degrees from additional spring features 110a and 110b. For example, cut slot 112a may be in between and equidistant to additional spring features 110a and 110b. In some examples, cut slot 112b may be 90 degrees from additional spring features 110a and 110b. For example, cut slot 112b may be in between and equidistant to additional spring features 110a and 110b. In some examples, cut slot 112a and cut slot 112b are at the same vertical height.

In some examples, cut slot 112a is square or rectangular shaped. In some examples, cut slot 112a is cut at an angle. For example, cut slot 112a may be angled such that a spring feature from a male terminal snap into cut slot 112a when the male terminal is engaged with female terminal 100. For example, this may lock the male terminal to the female terminal 100 such that no vertical or rotational movement of the male terminal may occur without the same movement by female terminal 100.

In one or more embodiments, additional spring features 110a and 110b are defined by vertical portion 104. In some examples, additional spring feature 110a is defined on an opposite side of vertical portion 104 from additional spring feature 110b (i.e., they are 180 degrees apart). For example, additional spring feature 110a may be 90 degrees from cut slots 112a and 112b. For example, additional spring feature 110a may be in between and equidistant to cut slots 112a and 112b. For example, additional spring feature 110b may be 90 degrees from cut slots 112a and 112b. For example, additional spring feature 110b may be in between and equidistant to cut slots 112a and 112b.

In some examples, additional spring features 110a and 110b may be defined at different vertical heights such that they are an upper spring feature and a lower spring feature. For example, upper spring feature 110a may be placed higher than lower spring feature 110b. For example, upper spring feature 110a may be defined at the same height as cut slot 112a and/or cut slot 112b. For example, lower spring feature 110b may be defined at a lower height than cut slot 112a and/or cut slot 112b. In some examples, additional spring features 110a-110b and cut slots 112a-112b may be formed through a sheet metal stamping process.

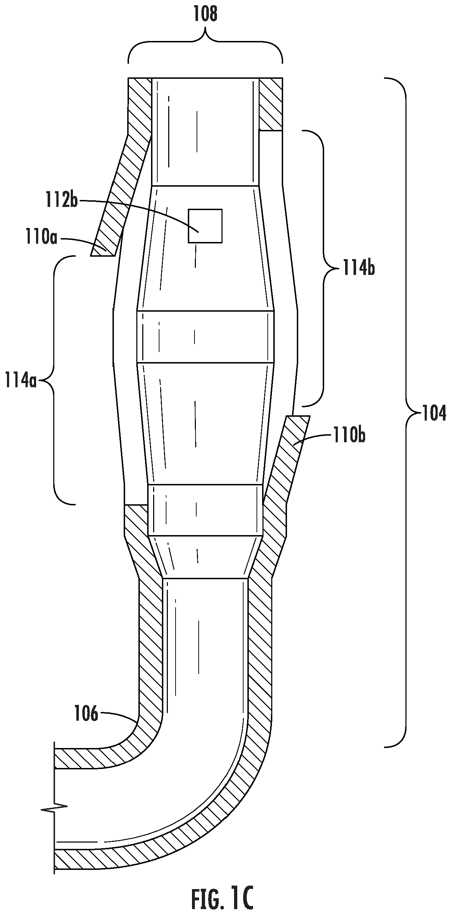

Turning now to FIG. 1C, a cross-section view of female terminal 100 is illustrated. As shown in FIG. 1C, additional spring feature 110a and additional spring feature 110b may be flag snap features. For example, additional spring feature 110a and additional spring feature 110b may spring outwards away from vertical portion 104. In some examples, additional spring feature 110a and additional spring feature 110b spring outwards in opposite directions. For example, additional spring feature 110a may spring outwards as it slopes vertically downward and additional spring feature 110b may spring outwards as it slopes vertically upward. Additional spring feature 110a may spring outwards above a vertical opening 114a. For example, vertical opening 114a may extend downwards to a height across from to additional spring feature 110b. Additional spring feature 110b may spring outwards below a vertical opening 114b. For example, vertical opening 114b may extend upwards to a height across from additional spring feature 110a.

In one or more embodiments, a printed circuit board may be coupled to additional spring features 110a and 110b. For example, additional spring feature 110a may exert compressive force downwards on the top of a printed circuit board and additional spring feature 110b may exert compressive force upwards on the bottom of the same printed circuit board.

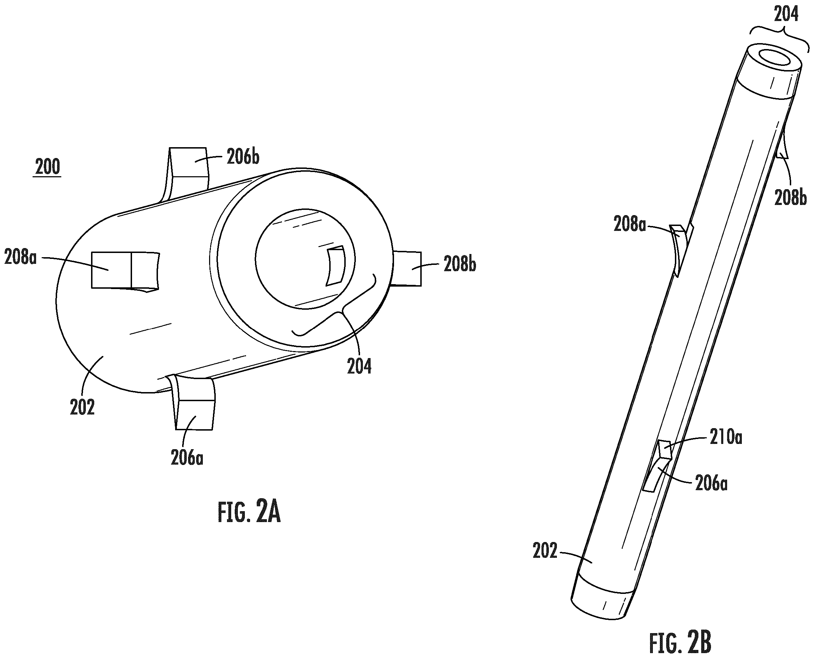

Turning now to FIG. 2A, an example male terminal 200 is depicted. In one or more embodiments, the male terminal 200 is a cylindrical terminal. In some examples, male terminal 200 is defined by a body 202 made of sheet metal. In some examples, body 202 maintains a uniform diameter throughout male terminal 200 other than otherwise altered by spring features and openings. In some examples, the diameter of body 202 is narrower than a diameter of opening 108 of female terminal 100, such that the male terminal 200 may engage with female terminal 100. For example, in order to fit in and lock with female terminal 100, the diameter of male terminal 200 may be 1mm.

In some examples, male terminal 200 defines an opening 204. For example, opening 204 may be an entrance to a hollow tube through the body 202. In some examples, the hollow tube maintains a uniform diameter throughout male terminal 200 other than otherwise altered by spring features and openings.

In one or more embodiments, the male terminal 200 comprises a set of spring features 206a-206b. In some examples, the male terminal 200 comprises an additional set of spring features 208a-208b. These spring features 206a-206b and additional spring features 208a-208b may be formed through a sheet metal stamping process and made of the same material as the body 202. In some examples, spring features 206a-206b and additional spring features 208a-208b may have a thickness of 0.2mm and spring outwards more than 0.25mm from an outside of male terminal 200 in order to engage with and release from female terminal 100. In some examples, spring features 206a-206b and additional spring features 208a-208b may be less than 1mm in height.

In some examples, spring feature 206a is defined on an opposite side of body 202 from spring feature 206b (i.e., they are 180 degrees apart). For example, spring feature 206a may be 90 degrees from additional spring features 208a and 208b. For example, spring feature 206a may be in between and equidistant to spring features 208a and 208b. In some examples, spring feature 206b may be 90 degrees from additional spring features 208a and 208b. For example, spring feature 206b may be in between and equidistant to additional spring features 208a and 208b. In some examples, spring feature 206a and spring feature 206b are at the same vertical height.

Turning now to FIG. 2B, a perspective view of the male terminal 200 is shown. In one or more embodiments, additional spring features 208a and 208b are defined by body 202. In some examples, additional spring feature 208a is defined on an opposite side of body 202 from additional spring feature 208b (i.e., they are 180 degrees apart). For example, additional spring feature 208a may be 90 degrees from spring features 206a and 206b. For example, additional spring feature 208a may be in between and equidistant to spring features 206a and 206b. For example, additional spring feature 208b may be 90 degrees from spring features 206a and 206b. For example, additional spring feature 208b may be in between and equidistant to spring features 206a and 206b.

In some examples, additional spring features 208a and 208b may be defined at different vertical heights such that they are a lower spring feature 208a and an upper spring feature 208b. For example, upper spring feature 208b may be placed higher than lower spring feature 208a. In some examples, this may allow upper spring feature 208b to exert compressive force on a top of a printed circuit board and lower spring feature 208a to exert compressive force on a bottom of a printed circuit board.

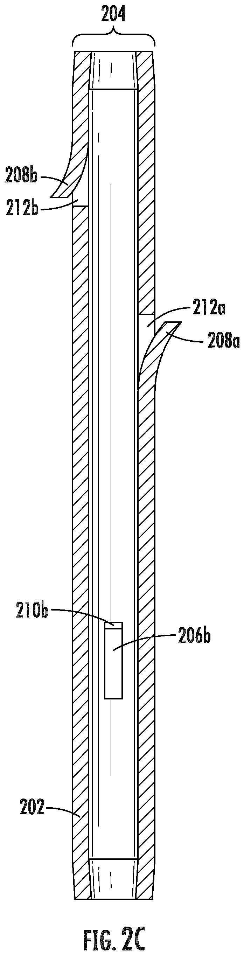

In some examples, spring feature 206a is adjacent to a spring feature opening 210a on the body 202 of male terminal 200. In some examples, spring feature 206a is a flag snap feature. For example, the spring feature 206a may spring outwards from the spring feature opening 210a. In some examples, spring feature 206a is configured to lock with a cut slot (e.g., cut slot 112a) from female terminal 100. As shown in FIG. 2C, spring feature 206b is adjacent to a spring feature opening 210b on the body 202 of male terminal 200. In some examples, spring feature 206b is a flag snap feature. For example, the spring feature 206b may spring outwards from the spring feature opening 210b. In some examples, spring feature 206b is configured to lock with a cut slot (e.g., cut slot 112b) from female terminal 100.

Turning now to FIG. 2C, a cross-section view of male terminal 200 is illustrated. As shown in FIG. 2C, additional spring feature 208a and additional spring feature 208b may be flag snap features. For example, additional spring feature 208a and additional spring feature 208b may spring outwards away from body 202. In some examples, additional spring feature 208a and additional spring feature 208b spring outwards in opposite directions. For example, additional spring feature 208b may spring outwards as it slopes vertically downward and additional spring feature 208a may spring outwards as it slopes vertically upward. Additional spring feature 208a may spring outwards adjacent to additional spring feature opening 212a. For example, additional spring feature opening 212a may be filled by additional spring feature 208a if pushed inwards toward body 202. Additional spring feature 208b may spring outwards adjacent to additional spring feature opening 212b. For example, additional spring feature opening 212b may be filled by additional spring feature 208a if pushed inwards toward body 202.

In one or more embodiments, a printed circuit board may be coupled to additional spring features 208a and 208b. For example, additional spring feature 208b may exert compressive force downwards on the top of a printed circuit board and additional spring feature 208a may exert compressive force upwards on the bottom of the printed circuit board.

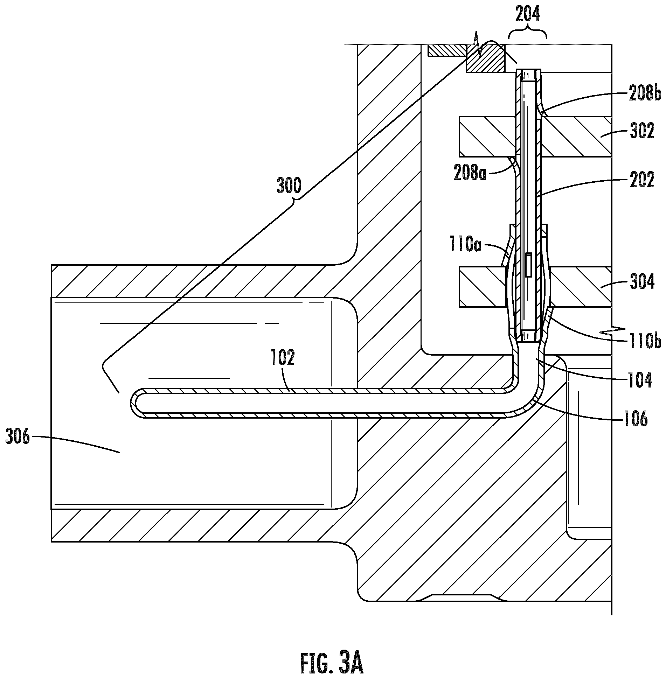

Turning now to FIG. 3A, an example of a locking conductor 300 comprising the male terminal 200 locked to the female terminal 100 is provided. For example, the male terminal 200 may engage with the female terminal 100 when the body 202 of the male terminal 200 is inserted through opening 108 of female terminal 100. In some examples, the male terminal 200 and the female terminal 100 are locked together by a snap locking mechanism (e.g., by locking spring features 206a-206b with cut slots 112a-112b) at an engagement area of vertical portion 104 above bend 106. The male terminal 200 and the female terminal 100 may be locked together to support stacking printed circuit boards (e.g., printed circuit boards 302-304) for use in an assembly. An example of one such assembly is a hydrogen sensor.

In one or more embodiments, the horizontal portion 102 of female terminal 100 is embedded within housing 306. In some examples, bend 106 and part of vertical portion 104 are further imbedded in housing 306. In some examples, this provides a female terminal 100 and male terminal 200 with strength and stability. This may allow female terminal 100 and male terminal 200 to lock printed circuit boards 302-304 into place.

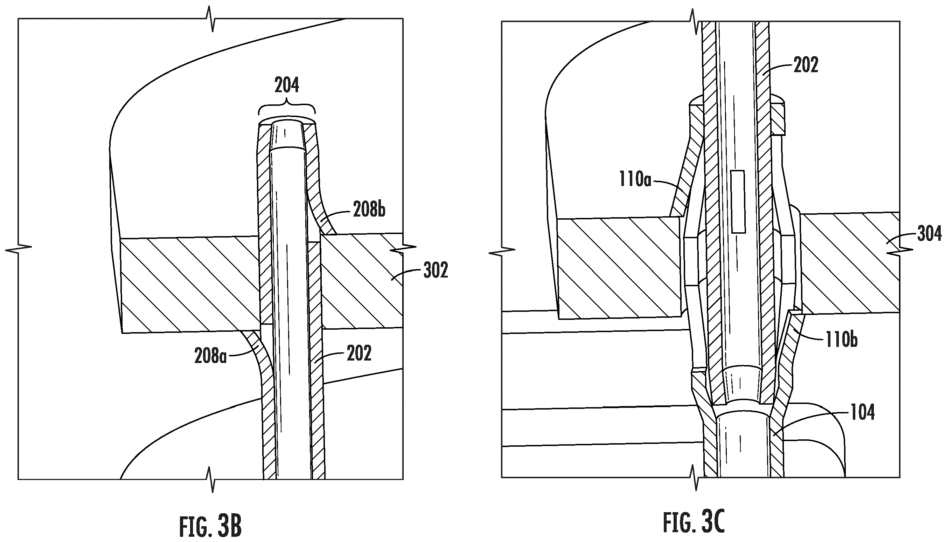

Turning now to FIG. 3B, a close-up view of male terminal 200 coupled to first printed circuit board 302 is provided. In one or more embodiments, printed circuit board 302 is locked in place by first additional set of spring features 208a-208b of male terminal 200. In some examples, printed circuit board 302 is inserted from the top of male terminal 200 until additional spring feature 208a does not allow it to move further, at which point additional spring feature 208b is released and does not allow printed circuit board 302 to move upwards. Additional spring feature 208b may exert compressive force downwards on the top of printed circuit board 302 and additional spring feature 208a may exert compressive force upwards on the bottom of printed circuit board 302. Printed circuit board 302 may be electrically coupled to printed circuit board 304 via male terminal 200 and female terminal 100 when these terminals are made of sheet metal or another conductive material.

Turning now to FIG. 3C, a close-up view of female terminal 100 coupled to printed circuit board 304 is provided. In one or more embodiments, second printed circuit board 304 is locked in place by second additional set of spring features 110a-110b of female terminal 100. In some examples, printed circuit board 304 is inserted from the top of female terminal 100 until additional spring feature 110b does not allow it to move further, at which point additional spring feature 110a is released and does not allow printed circuit board 304 to move upwards. Additional spring feature 110a may exert compressive force downwards on the top of printed circuit board 304 and additional spring feature 110b may exert compressive force upwards on the bottom of printed circuit board 304. Printed circuit board 304 may be electrically coupled to printed circuit board 302 via female terminal 100 and male terminal 200. For example, male terminal 200 and female terminal 100 may be made of a conductive sheet metal material such as copper, copper alloy, brass, phosphor bronze, Beryllium Copper, steel, and/or the like.

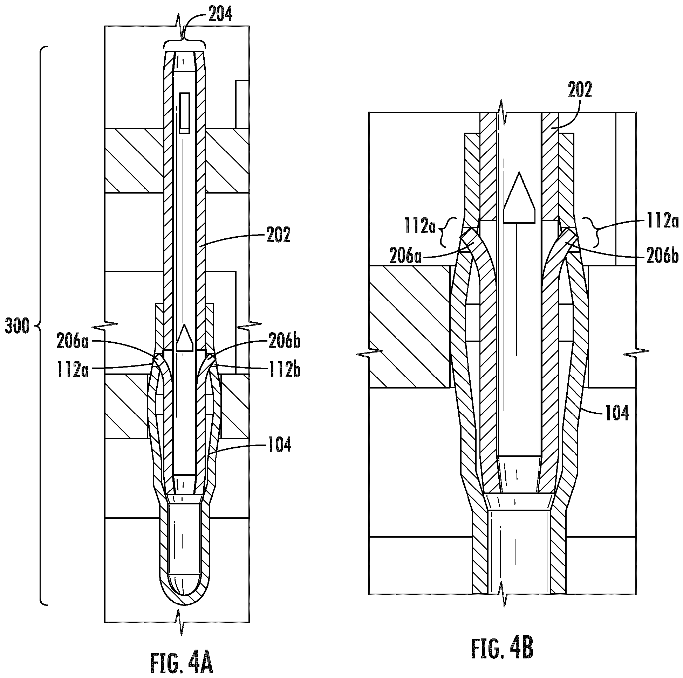

Turning now to FIG. 4A, an example locking conductor 300 is illustrated comprising a male terminal 200 and a female terminal 100. In this example, the cut slots 112 and 112b of the female terminal 100 are locked to the spring features 206a and 206b. In some examples, locking the female terminal 100 with the male terminal 200 provides reliability, longevity, and strength to the locking conductor 300 compared to a female terminal 100 or a male terminal 200 alone. In addition, an example locking conductor 300 allows electrical connection between printed circuit boards (e.g., printed circuit boards 302-304) with reduced product, process, and safety costs compared to existing systems such as soldering. In addition, an example locking conductor 300 allows electrical connection between printed circuit boards (e.g., printed circuit boards 302-304) with increased strength, longevity, and ease of use compared to existing systems such as soldering.

Turning now to FIG. 4B, a close-up view of locking conductor 300 comprising spring features 206a-206b of male terminal 200 locked with cut slots 112a-112b of female terminal 100 is provided in accordance with example embodiments. In one or more embodiments, spring feature 206a is bent outwards away from body 202 of male terminal 200. In this example embodiment, spring feature 206a springs further outwards towards the top of male terminal 200. In some examples, spring feature 206a snaps into cut slot 112a. For example, vertical portion 104 of female terminal 100 may be sloping towards male terminal 200 (i.e., decreasing in diameter) at the point of cut slot 112a. Therefore, the example cut slot 112a is angled towards body 202 of male terminal 200 while spring feature 206a is angled away from body 202 of male terminal 200. In this example circumstance, the spring feature 206a snaps into cut slot 112a when male terminal 200 is inserted from the top of female terminal 100. The example spring feature 206a is compressed until it is released into cut slot 112a, preventing the male terminal 200 from moving up or down relative to female terminal 100. In some examples, the spring feature 206a compresses against an edge of cut slot 112a, creating friction which prevents movement of female terminal 100 relative to male terminal 200 and vice versa. In some examples, sides of spring feature 206a are restricted by sides of cut slot 112a to prevent rotational movement of female terminal 100 relative to male terminal 200 and vice versa.

In one or more embodiments, spring feature 206b is bent outwards away from body 202 of male terminal 200. In this example embodiment, spring feature 206b springs further outwards towards the top of male terminal 200. In some examples, spring feature 206b snaps into cut slot 112b. For example, vertical portion 104 of female terminal 100 may be sloping towards male terminal 200 at the point of cut slot 112b. Therefore, the example cut slot 112b is angled towards body 202 of male terminal 200 while spring feature 206b is angled away from body 202 of male terminal 200. In this example circumstance, the spring feature 206b snaps into cut slot 112b when male terminal 200 is inserted from the top of female terminal 100. The example spring feature 206b is compressed until it is released into cut slot 112b, preventing the male terminal 200 from moving up or down relative to female terminal 100. In some examples, the spring feature 206b compresses against an edge of cut slot 112b, creating friction which prevents movement of female terminal 100 relative to male terminal 200 and vice versa. In some examples, sides of spring feature 206b are restricted by sides of cut slot 112b to prevent rotational movement of female terminal 100 relative to male terminal 200 and vice versa.

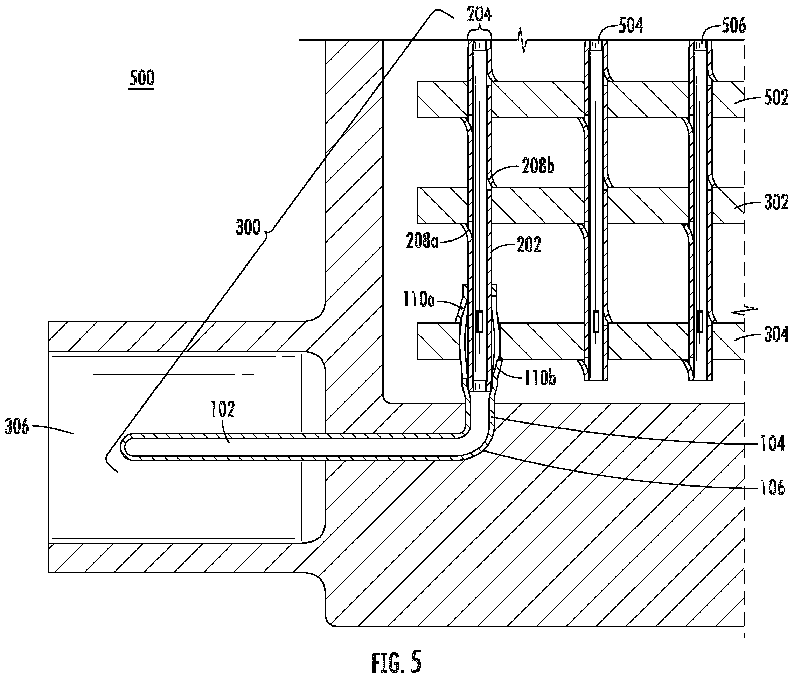

Turning now to FIG. 5, an assembly 500 is illustrated of a system with several printed circuit boards. For example, an assembly 500 may include printed circuit boards 302, 304, and 502. In the depicted example, printed circuit boards 302, 304, and 502 are electrically connected by a locking conductor 300 and two additional male terminals 504-506. However, in other embodiments, multiple locking conductors 300 may be used to electrically connect several printed circuit boards. A locking conductor 300 may be used in combination with additional female terminals to electrically connect a series of printed circuit boards. Electrically connecting printed circuit boards using example locking conductor 300 allows flatness of printed circuit board assemblies to be maintained, increases joint strength of assembly 500, and may be used in a wide variety of applications. For example, locking conductor 500 may be used to connect multiple printed circuit boards in a hydrogen sensor.

### Conclusion

The above descriptions of various embodiments of the subject disclosure and corresponding figures and what is described in the Abstract, are described herein for illustrative purposes, and are not intended to be exhaustive or to limit the disclosed embodiments to the precise forms disclosed. It is to be understood that one of ordinary skill in the art may recognize that other embodiments having modifications, permutations, combinations, and additions can be implemented for performing the same, similar, alternative, or substitute functions of the disclosed subject matter, and are therefore considered within the scope of this disclosure. Therefore, the disclosed subject matter should not be limited to any single embodiment described herein, but rather should be construed in breadth and scope in accordance with the appended claims below. Moreover, although the foregoing descriptions and the associated drawings describe example embodiments in the context of certain example combinations of elements and/or functions, it should be appreciated that different combinations of elements and/or functions may be provided by alternative embodiments without departing from the scope of the appended claims. In this regard, for example, different combinations of elements and/or functions than those explicitly described above are also contemplated as may be set forth in some of the appended claims. Although specific terms are employed herein, they are used in a generic and descriptive sense only and not for purposes of limitation.

## Claims

1. An apparatus, comprising:
a male terminal; and
a female terminal,
wherein the female terminal comprises a set of cut slots,
wherein the male terminal comprises a set of spring features, and
wherein the set of spring features are configured to lock with the set of cut slots when the male terminal and the female terminal are engaged.

2. The apparatus of claim 1, wherein the set of spring features comprises a set of flag snap features.

3. The apparatus of claim 1, wherein the set of spring features comprises a first spring feature and a second spring feature, wherein the first spring feature and the second spring feature are 180 degrees apart.

4. The apparatus of claim 1, wherein at least one of the male terminal or the female terminal comprises an additional set of spring features, and wherein the additional set of spring features is configured to be coupled to a printed circuit board.

5. The apparatus of claim 4, wherein the set of spring features and the additional set of spring features each comprise two spring features, and wherein each spring feature of the set of spring features and the additional set of spring features are 90 degrees apart.

6. The apparatus of claim 4, wherein the additional set of spring features comprises an upper spring feature and a lower spring feature, wherein the upper spring feature and the lower spring feature are 180 degrees apart.

7. The apparatus of claim 1, wherein the male terminal comprises a first additional set of spring features configured to be coupled to a first printed circuit board and the female terminal comprises a second additional set of spring features configured to be coupled to a second printed circuit board.

8. The apparatus of claim 1, wherein each of the male terminal and the female terminal are cylindrical.

9. The apparatus of claim 1, wherein each of the male terminal and the female terminal are made of sheet metal.

10. The apparatus of claim 1, wherein the apparatus comprises a hydrogen sensor.

11. The apparatus of claim 1, wherein the female terminal is partially embedded within a housing.

12. The apparatus of claim 1, wherein the female terminal comprises a 90-degree bend underneath an engagement area, wherein the female terminal and the male terminal are engaged at the engagement area.
